# EUROPEAN PATENT SPECIFICATION

(11) **EP 3 109 015 B1**
(45) Date of publication and mention of the grant of the patent: **07.03.2018**
(21) Application number: 15173953.9
(22) Date of filing: 25.06.2015
(51) Int. Cl.: B26B 21/48, B26B 21/40, H05K 1/02, H05K 3/30

(54) **METHOD OF ASSEMBLING A PERSONAL CARE PRODUCT**
VERFAHREN ZUR MONTAGE EINES KÖRPERPFLEGEPRODUKTS
PROCÉDÉ D'ASSEMBLAGE D'UN PRODUIT DE SOINS PERSONNELS

(43) Date of publication of application: 28.12.2016
(73) Proprietor: The Gillette Company LLC, Boston, MA 02127 (US)
(72) Inventor: Broemse, Norbert, 61476 Kronberg (DE); Heubach, Klaus, 61476 Kronberg (DE)
(74) Representative: Kohol, Sonia

(56) References cited:
- US-A1- 2005 218 513
- US-A1- 2010 031 510
- US-A1- 2010 212 939
- US-A1- 2014 048 310

## Description

### FIELD OF THE INVENTION

The present invention relates to electronic personal care products and more particularly to heated razors for wet shaving.

### BACKGROUND OF THE INVENTION

Users of wet-shave razors generally appreciate a feeling of warmth against their skin during shaving. The warmth feels good, resulting in a more comfortable shaving experience. Various attempts have been made to provide a warm feeling during shaving. For example, shaving creams have been formulated to react exothermically upon release from the shaving canister, so that the shaving cream imparts warmth to the skin. Also, various ways of delivering heat through the razor cartridge have also been proposed in the patent literature. It has also been proposed in the patent literature to heat the blades, which may decrease the force required to cut the hair. Additional electronic components may be required to deliver heat to the skin in a safe and reliable manner. Furthermore, electronic components must be small to fit within a consumer appliance, such as a razor. Accordingly, electrical components and fittings are typically very delicate and can break easily. A shaving razor comprising a heating element according to the state of the art is known for example from US 2010/0031510 A1. In order to provide a safe and functional cartridge capable of delivering heat to the skin, the electrical components of the heating member must be sealed against water ingress in a reliable cost effective manner.

Accordingly, there is a need to prevent water ingress into the electronics of a heating element and/or sensor of a personal care appliance, while also providing support and/or strain relief for the electrical connections.

### SUMMARY OF THE INVENTION

The invention features, in general, a simple, efficient method of assembling a heating element for a shaving razor by providing an insulating member having a base with a plurality of spaced apart electrical terminals. A flexible printed circuit board having a plurality of spaced apart electrical terminals is provided. The electrical terminals of the insulating member are soldered to the corresponding electrical terminals of the flexible printed circuit board. A liquid non electrically conductive underfiller encapsulant is dispensed between the base of the insulating member of the base of the flexible printed circuit board forming a water tight seal between each of the spaced apart electrical terminals of the insulating member and between each of the electrical terminals of the flexible printed circuit board by curing the liquid non electrically conductive underfiller encapsulant.

The invention also features, in general, a simple, efficient method of assembling an insulating member having a base with a plurality of spaced apart electrical terminals. A flexible printed circuit board having a plurality of spaced apart electrical terminals is provided. The electrical terminals of the insulating member are soldered to the corresponding electrical terminals of the flexible printed circuit board. A liquid non electrically conductive underfiller encapsulant is dispensed between the base of the insulating member the base of the flexible printed circuit board forming a water tight seal between each of the spaced apart electrical terminals of the insulating member and between each of the electrical terminals of the flexible printed circuit board by curing the liquid non electrically conductive underfiller encapsulant.

The details of one or more embodiments of the invention are set forth in the accompanying drawings and the description below. It is understood that certain embodiments may combine elements or components of the invention, which are disclosed in general, but not expressly exemplified or claimed in combination, unless otherwise stated herein. Other features and advantages of the invention will be apparent from the description and drawings, and from the claims.

### BRIEF DESCRIPTION OF THE DRAWINGS

While the specification concludes with claims particularly pointing out and distinctly claiming the subject matter that is regarded as the present invention, it is believed that the invention will be more fully understood from the following description taken in conjunction with the accompanying drawings.
FIG. 1 is a perspective view of one possible embodiment of a shaving razor system.
FIG. 2 is an assembly view of one possible embodiment of a heating element that may be incorporated into the shaving razor system of FIG. 1.
FIG. 3 is perspective view of a portion of the heating element of FIG. 2.
FIG. 4 is a cross section view of the heating element, taken generally along the line 4-4 of FIG 3.
FIG. 5 is a cross section view of the heating element, taken generally along the line 5-5 of FIG 3.

### DETAILED DESCRIPTION OF THE INVENTION

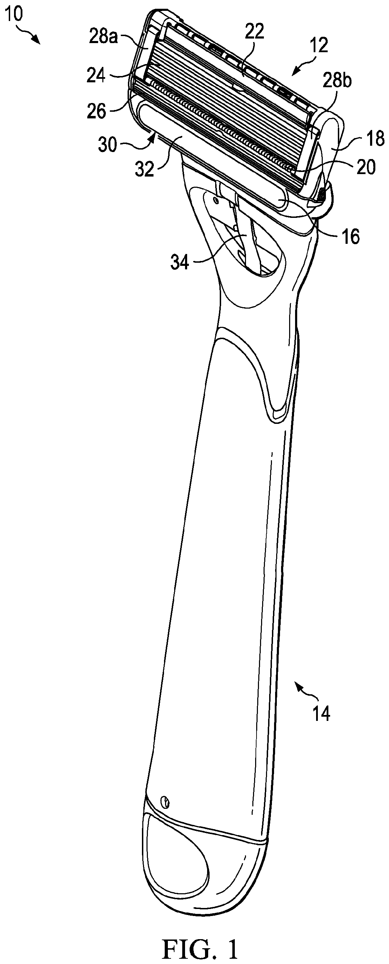

Referring to FIG. 1, one possible embodiment of the present disclosure is shown illustrating a shaving razor system 10. In certain embodiments, the shaving razor system 10 may include a shaving razor cartridge 12 mounted to a handle 14. The shaving razor cartridge 12 may be fixedly or pivotably mounted to the handle 14, depending on the overall desired cost and performance of the shaving razor system 10. The handle 14 may hold a power source, such as one or more batteries (not shown) that supply power to a heating element 16. In certain embodiments, the heating element 16 may comprise a metal, such as aluminum or steel. It is understood that the shaving razor system 10 may also include other electronic personal care products, such as toothbrushes, electric razors, or other products that are used in a wet environment.

The shaving razor cartridge 12 may be permanently attached or removably mounted from the handle 14, thus allowing the shaving razor cartridge 12 to be replaced. The shaving razor cartridge 12 may have a housing 18 with a guard 20, a cap 22 and one or more blades 24 mounted to the housing 18 between the cap 22 and the guard 20. The guard 20 may be toward a front portion of the housing 18 and the cap 22 may be toward a rear portion of the housing 18 (i.e., the guard 20 is in front of the blades 24 and the cap is behind the blades 24). The guard 20 and the cap 22 may define a shaving plane that is tangent to the guard 20 and the cap 22. The guard 20 may be a solid or segmented bar that extends generally parallel to the blades 24. In certain embodiments, the guard 20 may comprise a skin-engaging member 26 (e.g., a plurality of fins) in front of the blades 24 for stretching the skin during a shaving stroke. The skin-engaging member 26 may be insert injection molded or co-injection molded to the housing 18. However, other known assembly methods may also be used such as adhesives, ultrasonic welding, or mechanical fasteners. The skin engaging member 26 may be molded from a softer material (i.e., lower durometer hardness) than the housing 18. For example, the skin engaging member 26 may have a Shore A hardness of about 20, 30, or 40 to about 50, 60, or 70. A softer material may enhance skin stretching, as well as provide a more pleasant tactile feel against the skin of the user during shaving. A softer material may also aid in masking the less pleasant feel of the harder material of the housing 18 and/or the fins against the skin of the user during shaving.

In certain embodiments, the blades 24 may be mounted to the housing 18 and secured by one or more clips 28a and 28b. Other assembly methods known to those skilled in the art may also be used to secure and/or mount the blades 24 to the housing 18 including, but not limited to, wire wrapping, cold forming, hot staking, insert molding, ultrasonic welding, and adhesives. The clips 28a and 28b may comprise a metal, such as aluminum for acting as a sacrificial anode to help prevent corrosion of the blades 24. Although five blades 24 are shown, the housing 18 may have more or fewer blades depending on the desired performance and cost of the shaving razor cartridge 12.

In certain embodiments, it may be desirable to provide heat in front of the blades 24. For example, the heating element 16 may be positioned in front of the guard 20 and/or the skin engaging member 26. The heating element 16 may comprise a skin contacting surface 30 (e.g., a face plate 32) that delivers heat to a consumer's skin during a shaving stroke for an improved shaving experience. As will be described in greater detail below, the heating element 16 may be mounted to either the shaving razor cartridge 12 or to a portion of the handle 14. The heating element 16 may be in electrical communication with a power circuit via a flexible circuit 34.

The cap 22 may be a separate molded (e.g., a shaving aid filled reservoir) or extruded component (e.g., an extruded lubrication strip) that is mounted to the housing 18. In certain embodiments, the cap 22 may be a plastic or metal bar to aid in supporting the skin and define the shaving plane. The cap 22 may be molded or extruded from the same material as the housing 18 or may be molded or extruded from a more lubricious shaving aid composite that has one or more water-leachable shaving aid materials to provide increased comfort during shaving. The shaving aid composite may comprise a water-insoluble polymer and a skin-lubricating water-soluble polymer. Suitable water-insoluble polymers which may be used include, but are not limited to, polyethylene, polypropylene, polystyrene, butadiene-styrene copolymer (e.g., medium and high impact polystyrene), polyacetal, acrylonitrile-butadiene-styrene copolymer, ethylene vinyl acetate copolymer and blends such as polypropylene/polystyrene blend, may have a high impact polystyrene (i.e., Polystyrene-butadiene), such as Mobil 4324 (Mobil Corporation).

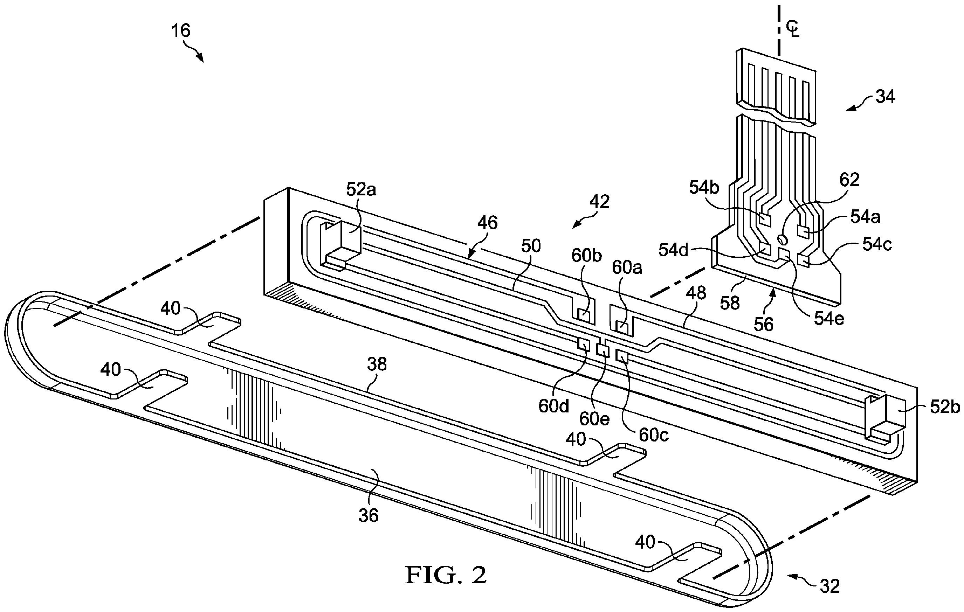

Referring to FIG. 2, one possible embodiment of a heating element 16 is shown that may be incorporated into the shaving razor system of FIG. 1. The heating element may comprise the face plate 32, an insulating member 42 and the flexible circuit 34. The face plate 32 may have a bottom surface 36 opposing the skin contacting surface 30 (skin contacting surface 30 is shown in FIG. 1). A perimeter wall 38 may define the bottom surface 36. It is understood that the perimeter wall 38 may be continuous or segmented (e.g., a plurality of legs or castellations). The perimeter wall 38 may have one or more legs 40 extending from the perimeter wall 38, transverse to and away from the bottom surface 36. For example, FIG. 2 illustrates four legs 40 extending from the perimeter wall 38. The legs 40 may facilitate locating and securing the heating element 16 during the assembly process. The insulating member 42 may be mounted to the face plate 32 and then secured to the housing 18. For example, the insulating member 42 may be positioned within the perimeter wall 38 and the face plate 32 may be mechanically secured to the housing 18. If added securement is desired, the insulating member 42 may be bonded (e.g., using adhesives) to the face plate 32. In certain embodiments, the insulating member 42 may comprise a ceramic or other material having high thermal conductivity and/or excellent electrical insulator properties. The insulating member 42 may have a first surface (not shown) that faces the bottom surface 36 of the face plate 32 and a second surface 46 opposite the first surface (not shown). The first surface may contact the bottom surface 36 to transfer heat to the face plate 32. The perimeter wall 38 may help contain and locate the insulating member 42. In certain embodiments, the insulating member 42 may be secured to the bottom surface 36 by various bonding techniques generally known to those skilled in the art.

The second surface 46 of the insulating member 42 may comprise a conductive heating track 48 that extends around a perimeter of the insulating member 42. An electrical circuit track 50 may also extend around a perimeter of the second surface 46. In certain embodiments, the electrical circuit track 50 may be positioned within the perimeter of the heating track 48. The electrical circuit track 50 may be spaced apart from the heating track 48, so it does not interfere with the function of the electrical circuit track 50. The electrical circuit track 50 may comprise a pair of thermal sensors 52a and 52b that are positioned on opposite lateral ends (e.g., on left and right sides) of the second surface 46 of the insulating member 42. In certain embodiments, the thermal sensors 52a and 52b may be NTC-type thermal sensors (negative temperature coefficient). It is understood that more than one thermal sensors 52a and 52b may be used depending on the desired cost and safety requirements for the heating element 16. In addition, the thermal sensors 52a and 52b may be positioned anywhere on the insulating member 42.

The positioning of the thermal sensors 52a and 52b opposite lateral ends of the second surface 46 of the insulating member 42 may provide for a safer and more reliable measurement of the temperature of the heating element 16 (e.g., the face plate 30) and/or the insulating member 42. For example, if only one end of the heating element 16 is exposed to cool water (e.g., when the shaving razor cartridge is being rinsed in between shaving strokes), that end of the heating element will be cooler than the other end of the heating element. Lateral heat flow from one end to the opposite of heating elements may be poor and temperature equalization may be limited by the heat resistance of the mechanical heater system. Accordingly, a single sensor or multiple sensor(s) that take an average temperature may not provide an accurate reading and may over heat the heating element, which may lead to burning of the skin. Power to the heating element 16 may never turn off because of the unbalanced temperature of the heating element 16 (i.e., the average temperature or the individual temperature of the single sensor exposed to the cool water may never be reached). Accordingly, the thermal sensors 52a, 52b may independently output a signal related to the temperature of the heating element 16 to the temperature control circuit, which is in electrical communication with the thermal sensors 50,52.

Similarly, if only one end of the heating element 16 is exposed to hot water (e.g., when the shaving razor cartridge is being rinsed in between shaving strokes), that end of the heating element will be hotter than the other end of the heating element 16. Accordingly, a single sensor or multiple sensor(s) that take an average temperature will not provide an accurate reading and may result in power to the heating element being cut off or reduced prematurely (resulting in the consumer not feeling a heating sensation during shaving). The thermal sensors 52a and 52b may also be spaced apart from the heating track 48 to provide a more accurate temperature reading. For example, thermal sensors 52a and 52b may be spaced apart by about 3mm to about 30mm depending on the desired accuracy and manufacturing costs. In certain embodiments, a protective coating may be layered over the electrical circuit track 50 and/or the heating track 48. If desired, the entire second surface may be covered in a protective coating to provide thermal isolation and/or prevent water ingress, which may lead to a malfunction of the electrical heat control circuit (e.g., damage of the sensors 52a and 52b, the electrical circuit track 50 and/or the heating track 48).

The electrical circuit track 50 and/or the heating track 48 may be electrically coupled to the flexible printed circuit board 34. In order for the electrical circuit track 50 and/or the heating track 48 to function properly, the connections between the flexible printed circuit board 34 and the electrical circuit track 50 and/or the heating track 48 must be sealed from water ingress. The flexible printed circuit board 34 may have a plurality of spaced apart electrical terminals 54a, 54b, 54c, 54d and 54e. It is understood the flexible printed circuit board 34 may have more or less spaced apart electrical terminals 54a, 54b, 54c, 54d and 54e depending on the desired number of electrical circuit tracks 50 and/or heating tracks 48. For example, the electrical terminals 54a, 54b may facilitate electrical connection for the heating track and the electrical terminals 54c, 54d may facilitate electrical connection for the electrical track 50 that is connected to the sensors 52a and 52b. The electrical terminal 54e may be a ground connection to the sensors 52a, 52b. In certain embodiments, the insulating member 42 may comprise a ceramic substrate having a plurality of spaced apart electrical terminals 60a, 60b, 60c, 60d and 60e that correspond to the spaced apart electrical terminals 54a, 54b, 54c, 54d and 54e on the flexible printed circuit board 34. It is understood insulating member 42 may have more or less spaced apart electrical terminals 60a, 60b, 60c, 60d and 60e depending on the desired number of electrical circuit tracks 50 and/or heating tracks 48. For example, the electrical terminals 60a and 60b may facilitate electrical connection for the heating track 48 and the electrical terminals 60c and 60d may facilitate electrical connection for the electrical track 50 that is connected to the sensors 52a and 52b. The electrical terminal 60e may be a ground connection to the sensors 52a and 52b.

The flexible printed circuit board 34 may have a bounded opening 62 extending completely through the flexible printed circuit board 34. The bounded opening 62 may be dimensioned to receive an underfiller encapsulant that is not electrically conductive to provide a water tight seal. For example, the bounded opening may have a diameter of about 0.5mm to about 2.5mm. In certain embodiments, the bounded opening 62 may be positioned between two or more of the spaced apart electrical terminals 54a, 54b, 54c, 54d and 54e. For example, FIG. 2 illustrates the bounded opening 62 between the electrical terminals 54a and 54b. The bounded opening 62 may be spaced apart from the electrical terminals 54a, 54b, 54c, 54d and 54e by about 0.1mm, 0.2mm or 0.3mm to about 0.4mm, 0.5mm or 0.6mm. The distance between the bounded opening 62 and the electrical terminals 54a, 54b, 54c, 54d and 54e may be substantially the same (e.g., within 10% of each other) to allow a similar flow path for the underfiller encapsulant. For example, if a difference in the distance between the bounded opening 62 and each of the electrical terminals 54a, 54b, 54c, 54d and 54e is too great, some of the electrical terminals 54a, 54b, 54c, 54d and 54e may not be sealed efficiently during assembly.

The flexible printed circuit board 34 may have a slot 56 that extends into the circuit board from an edge 58. As will be explained in greater detail below, the slot 56 may cut completely through the flexible printed circuit board 34 to facilitate an underfiller encapsulant that is non electrically conductive to provide a water tight seal. The slot 56 may be positioned along a center line "CL" of the flexible printed circuit board 34 to facilitate proper filling of the encapsulant. The slot 56 may be used instead of or in addition to the opening 62. The slot 56 may provide a larger possible area to fill in to for faster and more complete sealing. For example, the slot 56 may have a width "w₁" of about 0.5mm to about 5mm and a depth "d₁" of about 0.5mm to about 5mm.

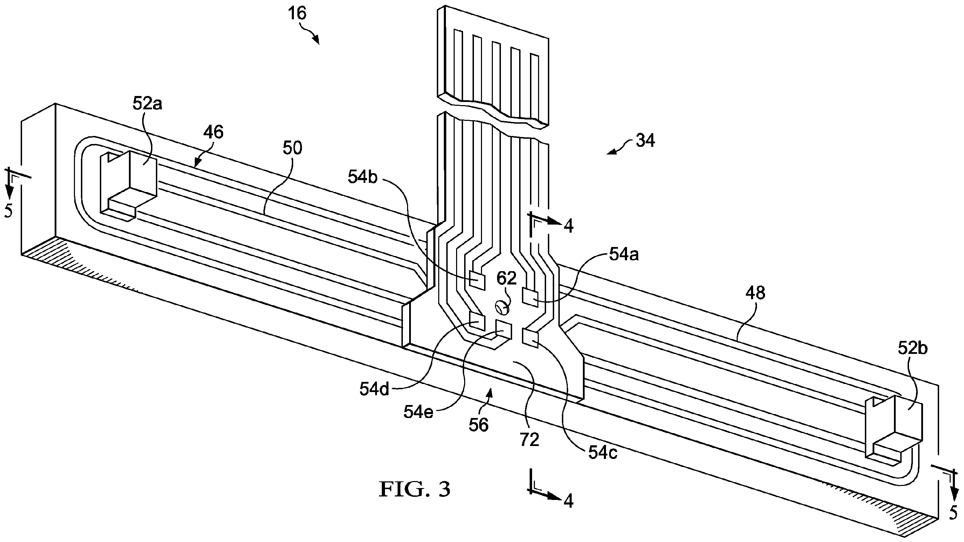

Referring to FIG. 3, a perspective view of the heating element 16 is shown with the flexible circuit 34 connected to the insulating member 42. The flexible circuit 34 may be placed over the insulating member 42 such that the electrical terminals 54a, 54b, 54c, 54d and 54e of the flexible circuit 34 generally align with the electrical terminals 60a, 60b, 60c, 60d and 60e on the insulating member. The underfiller encapsulant 72 may be applied through the opening 62 and/or the slot 56. If the slot 56 is utilized for the underfiller encapsulant, then the opening 62 may be able to be used as a locating hole to aid with alignment of the flexible circuit board 34 and the insulating member 42 instead of receiving the underfiller encapsulant 72. A locating hole may be advantageous because space is limited on the flexible circuit board 32 and the terminals 54a, 54b, 54c, 54d and 54e must be aligned correctly with the corresponding terminals 60a, 60b, 60c, 60d and 60e. The opening 62 may also be useful to help control any overflow of the underfiller encapsulant 72. Alternatively, the underfiller encapsulant 72 may be inserted between the flexible circuit 34 and the insulating member 42 from the edge 58 of the printed circuit board 34. For example, the underfiller encapsulant 72 may extend up to the edge 58 after filling is complete.

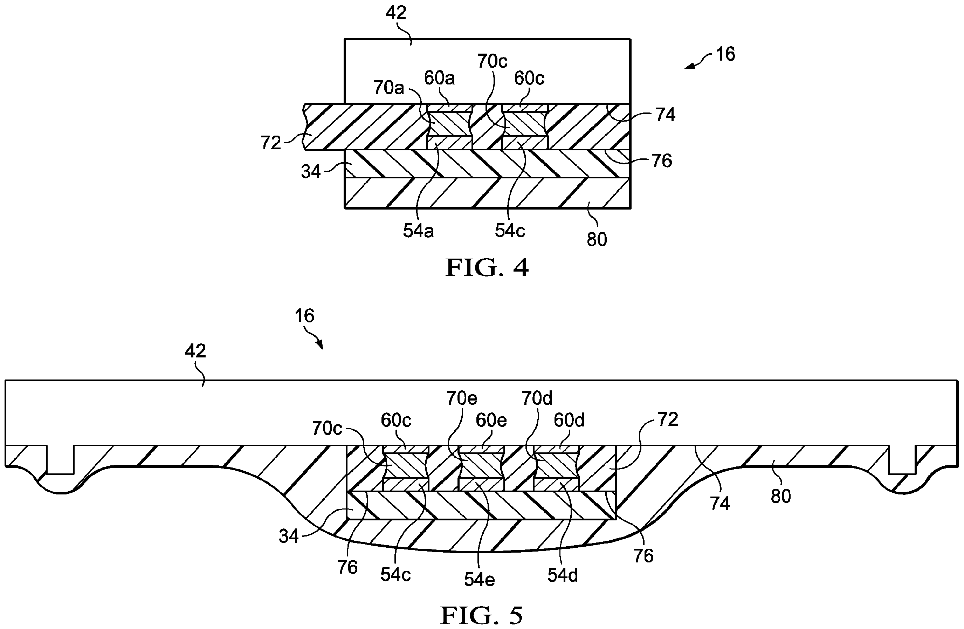

FIG. 4 illustrates a cross section view of the heating element 16, taken generally along the line 4-4 of FIG. 3. A solder pad joint 70a may be positioned between the electrical terminal 54a on the flexible circuit 34 and the electrical terminal 60a on the insulating member 42. Similarly, a solder pad joint 70b positioned between the electrical terminal 54b on the flexible circuit 34 and the electrical terminal 60b on the insulating member 42. As shown in FIG. 5, the heating element 16 may also comprise a plurality of solder pads 70c, 70d and 70e positioned between the electrical terminals 54c, 54d, and 54e of the flexible circuit 34 and the corresponding electrical terminals 60c, 60d and 60e on the insulating member 42. The solder pad joints 70a, 70b, 70c, 70d, and 70e may facilitate a mechanical and/or electrical coupling between the insulating member 42 and the flexible circuit 34.

As shown in FIGS. 4 and 5, the electrical terminals 60a, 60b, 60c, 60d and 60e may extend from a base 74 of the insulating member 42. The electrical terminals 54a, 54b, 54c, 54d and 54e may extend from a base 76 of the flexible circuit 34. The base 74 of the insulating member 42 may be spaced apart about 10µm to about 300µm and more preferably about 30µm to about 60µm from the base 76 of the flexible circuit 34 to provide sufficient spacing (e.g., a gap) for the underfiller encapsulant 72 to flow during assembly. The underfiller encapsulant 72 may bond to the printed circuit board 34 and/or the insulating member 42. The thickness of underfiller encapsulant 72 (e.g., the distance between the base 76 and the base 74) and the adhesion of underfiller encapsulant 72 to the printed circuit board 34 and/or the insulating member 42 may provide sufficient strain relief for the connection between the corresponding electrical terminals 54a, 54b, 54c, 54d, 54e, 60a, 60b, 60c, 60d and 60e. The added strain relief results in a safer, more robust assembly with a longer product life span and a lower risk of failure. In certain embodiments, a non-metallic coating 80 may be added over the flexible printed circuit board 34, the insulating member (e.g., the heating track 48 and the electrical track 50), and/or the sensors 52a and 52b. The non-metallic coating 80 may facilitate protection of the sensors 52a and 52b as well as the heating track 48 and electrical track 50 shown in FIG. 2. For example, the non-metallic coating 80 may be applied to the second surface 46 of the insulating member 42 either before or after the flexible circuit board 34 is connected and/or secured to the insulating member 42 (e.g., the non-metallic coating 80 may also be applied over the flexible circuit board 34 after the flexible circuit board 34 is secured to the insulating member 42. Examples of coatings may include Parylene®, Teflon®, epoxy or any combinations thereof.

Once the insulating member 42 and the flexible circuit 34 are mechanically coupled (e.g., soldering), the bounded opening 62 and/or the slot 56 may be completely or at least partially filled with the underfiller encapsulant 72. The underfiller encapsulant 72 may fill gaps by capillary action, which minimizes voids and stops filling once underfiller encapsulant 72 reaches the outer edges of the flexible circuit board 34 and the insulating member 42. The underfiller encapsulant 72 may be cured to harden and strengthen, for example, curing may comprise heating the underfiller encapsulant 72 to a temperature of about 90°C to about 200°C. As shown in FIGS. 4 and 5, the underfiller encapsulant 72 may flow around the connected electrical terminals 54a, 54b, 54c, 54d, 54e, 60a, 60b, 60c, 60d and 60e. The solder joints 70a, 70b, 70c, 70d, and 70e may prevent the underfiller encapsulant 72 from flowing in-between the corresponding electrical terminals 54a, 54b, 54c, 54d, 54e, 60a, 60b, 60c, 60d and 60e, which may obstruct a sufficient mechanical and/or electrical connection. Furthermore, the underfiller encapsulant 72 may offer support (e.g., provide strain relief) for the solder joint pads 70a, 70b, 70c, 70d, and 70e, which may prevent premature failure of the mechanical and/or electrical connection between the insulating member 42 and the flexible circuit 34.

The underfiller encapsulant may not only provide for a water tight seal, but also provide mechanical support around the electrical connection (e.g., strain relief) to prevent premature failure of the physical and/or electrical connection between the flexible circuit board 34 an the insulating member 42. Accordingly, the underfiller encapsulant may surround each of the electrical terminals 54a, 54b, 54c, 54d and 54e and each of the electrical terminals 60a, 60b, 60c, 60d and 60e. It is understood that there may be more than one bounded opening 62 and/or slot 56 depending on the spacing of the electrical terminals 54a, 54b, 54c, 54d and 54e and other factors, such as the viscosity of the underfiller encapsulant. It is also understood the bounded opening 62 and/or slot 56 may include any shape to allow proper filling. In certain embodiments, the underfiller encapsulant 72 may be applied from the outer edge 58 of the flexible printed circuit board 34.

The underfiller encapsulant may be a liquid with a viscosity of about 1 to about 100 mPas at 25 degrees Celsius that cures or hardens during the assembly process. For example, underfiller encapsulant may be thermally curable, radiation curable (e.g., light or ultraviolet), a thermoset, a thermoplastic, or curing may be initiated by adding a second component before or during dispensing. The underfiller encapsulant 72 may also be cured by heating the underfiller encapsulant 72 during dispensing to a first temperature and then heating the underfiller encapsulant to a second temperature after dispensing that is greater than the first temperature. In certain embodiments, the underfiller encapsulant may be opaque or colored to aid in inspection of the seal created by the underfiller encapsulant 72. The underfiller encapsulant may have a sufficient glass transition temperature so it does not deform or weaken from exposure to the temperature created when the heating element 16 is powered.

The dimensions and values disclosed herein are not to be understood as being strictly limited to the exact numerical values recited. Instead, unless otherwise specified, each such dimension is intended to mean both the recited value and a functionally equivalent range surrounding that value. For example, a dimension disclosed as "40 mm" is intended to mean "about 40 mm".

## Claims

1. A method of assembling a heating element (16) for a shaving razor comprising:
providing an insulating member (42) having a base (74) with a plurality of spaced apart electrical terminals (60a, 60b, 60c, 60d, 60e);
providing a flexible printed circuit board (34) having a plurality of spaced apart electrical terminals (54a, 54b, 54c, 54d, 54e);
soldering the electrical terminals (60a, 60b, 60c, 60d, 60e) of the insulating member (42) to the corresponding electrical terminals (54a, 54b, 54c, 54d, 54e) of the flexible printed circuit board (34);
dispensing a liquid non electrically conductive underfiller encapsulant (72) between the base (74) of the insulating member (42) and the base (76) of the flexible printed circuit board (34);
forming a water tight seal between each of the spaced apart electrical terminals (60a, 60b, 60c, 60d, 60e) of the insulating member (42) and between each of the electrical terminals (54a, 54b, 54c, 54d, 54e) of the flexible printed circuit board (34) by curing the liquid non electrically conductive underfiller encapsulant (72).

2. The method of claim 1 wherein liquid non electrically conductive underfiller encapsulant (72) fills the space between insulating member (42) and the flexible printed circuit board (34) by capillary action.

3. The method according to any one of the preceding claims wherein said curing comprises applying heat to the liquid non electrically conductive underfiller encapsulant (72).

4. The method according to any one of the preceding claims further comprising dispensing the liquid non electrically conductive underfiller encapsulant (72) between at least one pair of the spaced apart electrical terminals (54a, 54b, 54c, 54d, 54e) of the flexible printed circuit board (34) after soldering.

5. The method according to any one of the preceding claims wherein said curing comprises heating the liquid non electrically conductive underfiller encapsulant (72) to a temperature of 90°C to 200°C.

6. The method according to any one of the preceding claims further comprising providing a gap of 0.01mm to 0.3mm between the base (74) of the insulating member (42) and the base (76) of the flexible printed circuit board (34).

7. The method according to any one of the preceding claims further comprising dispensing a predetermined volume of the non electrically conductive underfiller encapsulant (72) into a slot (56) defined by the flexible printed circuit board (34).

8. The method according to any one of claims 1-6 further comprising dispensing a predetermined volume of the non electrically conductive underfiller encapsulant (72) into a hole (62) defined by the flexible printed circuit board (34).

9. The method according to any one of the preceding claims further comprising bonding the base (74) to the base (76).

10. The method according to any one of the preceding claims further comprising applying heat to the non electrically conductive underfiller encapsulant after dispensing.

11. The method according to any one of the preceding claims further comprising heating the non electrically conductive underfiller encapsulant (72) during dispensing to a first temperature and then heating the non electrically conductive underfiller encapsulant (72) to a second temperature after dispensing that is greater than the first temperature.

12. The method according to any one of the preceding claims wherein said dispensing is performed from an edge (58) of the flexible circuit board (34).

13. The method according to any one of the preceding claims further comprising applying a non-metallic coating (80) over the flexible printed circuit board (34).

14. The method according to any one of the preceding claims further comprising securing the insulating member (42) to a face plate (32).

15. The method of claim 14 further comprising securing the face plate (32) to a housing (18) of a shaving razor system (10).

## Patentansprüche

1. Verfahren zum Montieren eines Heizelements (16) für einen Rasierer, umfassend:
Bereitstellen eines Isolierelements (42) mit einer Basis (74) mit einer Vielzahl von beabstandeten elektrischen Anschlussklemmen (60a, 60b, 60c, 60d, 60e);
Bereitstellen einer flexiblen Leiterplatte (34) mit einer Vielzahl von beabstandeten elektrischen Anschlussklemmen (54a, 54b, 54c, 54d, 54e);
Löten der elektrischen Anschlussklemmen (60a, 60b, 60c, 60d, 60e) des Isolierelements (42) an die zugehörigen elektrischen Anschlussklemmen (54a, 54b, 54c, 54d, 54e) der flexiblen Leiterplatte (34);
Abgeben eines flüssigen, nicht Strom leitenden Unterfüllungs-Verkapselungsstoffs (72) zwischen der Basis (74) des Isolierelements (42) und der Basis (76) der flexiblen Leiterplatte (34);
Bilden einer wasserdichten Dichtung zwischen jeder der beabstandeten elektrischen Anschlussklemmen (60a, 60b, 60c, 60d, 60e) des Isolierelements (42) und zwischen jeder der elektrischen Anschlussklemmen (54a, 54b, 54c, 54d, 54e) der flexiblen Leiterplatte (34) durch Aushärten des flüssigen, nicht Strom leitenden Unterfüllungs-Verkapselungsstoffs (72).

2. Verfahren nach Anspruch 1, wobei flüssiger, nicht Strom leitender Unterfüllungs-Verkapselungsstoff (72) den Raum zwischen dem Isolierelement (42) und der flexiblen Leiterplatte (34) durch Kapillarwirkung füllt.

3. Verfahren nach einem der vorstehenden Ansprüche, wobei das Aushärten Anwenden von Wärme auf den flüssigen, nicht Strom leitenden Unterfüllungs-Verkapselungsstoff (72) umfasst.

4. Verfahren nach einem der vorstehenden Ansprüche, ferner umfassend Abgeben des flüssigen, nicht Strom leitenden Unterfüllungs-Verkapselungsstoffs (72) zwischen mindestens einem Paar der beabstandeten elektrischen Anschlussklemmen (54a, 54b, 54c, 54d, 54e) der flexiblen Leiterplatte (34) nach Löten.

5. Verfahren nach einem der vorstehenden Ansprüche, wobei das Aushärten Erhitzen des flüssigen, nicht Strom leitenden Unterfüllungs-Verkapselungsstoffs (72) auf eine Temperatur von 90 °C bis 200 °C umfasst.

6. Verfahren nach einem der vorstehenden Ansprüche, ferner umfassend Bereitstellen einer Lücke von 0,01 mm bis 0,3 mm zwischen der Basis (74) des Isolierelements (42) und der Basis (76) der flexiblen Leiterplatte (34).

7. Verfahren nach einem der vorstehenden Ansprüche, ferner umfassend Abgeben eines vorbestimmten Volumens des nicht Strom leitenden Unterfüllungs-Verkapselungsstoffs (72) in einen Schlitz (56), der durch die flexible Leiterplatte (34) definiert ist.

8. Verfahren nach einem der Ansprüche 1-6, ferner umfassend Abgeben eines vorbestimmten Volumens des nicht Strom leitenden Unterfüllungs-Verkapselungsstoffs (72) in eine Öffnung (62), die durch die flexible Leiterplatte (34) definiert ist.

9. Verfahren nach einem der vorstehenden Ansprüche, ferner umfassend Verkleben der Basis (74) mit der Basis (76).

10. Verfahren nach einem der vorstehenden Ansprüche, ferner umfassend Anwenden von Wärme auf den nicht Strom leitenden Unterfüllungs-Verkapselungsstoff nach dem Abgeben.

11. Verfahren nach einem der vorstehenden Ansprüche, ferner umfassend Erhitzen des nicht Strom leitenden Unterfüllungs-Verkapselungsstoffs (72) während des Abgebens auf eine erste Temperatur und dann Erhitzen des nicht Strom leitenden Unterfüllungs-Verkapselungsstoffs (72) auf eine zweite Temperatur nach dem Abgeben, die höher ist als die erste Temperatur.

12. Verfahren nach einem der vorstehenden Ansprüche, wobei das Abgeben von einem Rand (58) der flexiblen Leiterplatte (34) durchgeführt wird.

13. Verfahren nach einem der vorstehenden Ansprüche, ferner umfassend Auftragen einer nicht-metallischen Beschichtung (80) über die flexible Leiterplatte (34).

14. Verfahren nach einem der vorstehenden Ansprüche, ferner umfassend Befestigen des Isolierelements (42) an einer Kopfplatte (32).

15. Verfahren nach Anspruch 14, ferner umfassend Befestigen der Kopfplatte (32) an einem Gehäuse (18) eines Rasierersystems (10).

## Revendications

1. Procédé d'assemblage d'un élément chauffant (16) pour un rasoir de rasage, comprenant :
la fourniture d'un élément d'isolation (42) ayant une base (74) avec une pluralité de bornes électriques espacées (60a, 60b, 60c, 60d, 60e) ;
la fourniture d'une carte à circuit imprimé souple (34) ayant une pluralité de bornes électriques espacées (54a, 54b, 54c, 54d, 54e) ;
le soudage des bornes électriques (60a, 60b, 60c, 60d, 60e) de l'élément d'isolation (42) aux bornes électriques correspondantes (54a, 54b, 54c, 54d, 54e) de la carte à circuit imprimé souple (34) ;
la distribution d'un agent d'encapsulation de remplissage liquide non électroconducteur (72) entre la base (74) de l'élément d'isolation (42) et la base (76) de la carte à circuit imprimé souple (34) ;
la formation d'un joint étanche à l'eau entre chacune des bornes électriques espacées (60a, 60b, 60c, 60d, 60e) de l'élément d'isolation (42) et entre chacune des bornes électriques (54a, 54b, 54c, 54d, 54e) de la carte à circuit imprimé souple (34) par durcissement de l'agent d'encapsulation de remplissage liquide non électroconducteur (72).

2. Procédé selon la revendication 1, dans lequel l'agent d'encapsulation de remplissage liquide non électroconducteur (72) remplit l'espace entre l'élément d'isolation (42) et la carte à circuit imprimé souple (34) par action capillaire.

3. Procédé selon l'une quelconque des revendications précédentes, dans lequel ledit durcissement comprend l'application de chaleur à l'agent d'encapsulation de remplissage liquide non électroconducteur (72).

4. Procédé selon l'une quelconque des revendications précédentes, comprenant en outre la distribution de l'agent d'encapsulation de remplissage liquide non électroconducteur (72) entre au moins une paire des bornes électriques espacées (54a, 54b, 54c, 54d, 54e) de la carte à circuit imprimé souple (34) après soudure.

5. Procédé selon l'une quelconque des revendications précédentes, dans lequel ledit durcissement comprend le chauffage de l'agent d'encapsulation de remplissage liquide non électroconducteur (72) à une température de 90 °C à 200 °C.

6. Procédé selon l'une quelconque des revendications précédentes, comprenant en outre la fourniture d'un écartement de 0,01 mm à 0,3 mm entre la base (74) de l'élément d'isolation (42) et la base (76) de la carte à circuit imprimé souple (34).

7. Procédé selon l'une quelconque des revendications précédentes, comprenant en outre la distribution d'un volume prédéterminé de l'agent d'encapsulation de remplissage non électroconducteur (72) dans une fente (56) définie par la carte à circuit imprimé souple (34).

8. Procédé selon l'une quelconque des revendications 1 à 6, comprenant en outre la distribution d'un volume prédéterminé de l'agent d'encapsulation de remplissage non électroconducteur (72) dans un trou (62) défini par la carte à circuit imprimé souple (34).

9. Procédé selon l'une quelconque des revendications précédentes, comprenant en outre la liaison de la base (74) à la base (76).

10. Procédé selon l'une quelconque des revendications précédentes, comprenant en outre l'application de chaleur à l'agent d'encapsulation de remplissage non électroconducteur après distribution.

11. Procédé selon l'une quelconque des revendications précédentes, comprenant en outre le chauffage de l'agent d'encapsulation de remplissage non électroconducteur (72) pendant la distribution à une première température puis le chauffage de l'agent d'encapsulation de remplissage non électroconducteur (72) à une deuxième température après distribution, laquelle est supérieure à la première température.

12. Procédé selon l'une quelconque des revendications précédentes, dans lequel ladite distribution est effectuée à partir d'un bord (58) de la carte à circuit flexible (34).

13. Procédé selon l'une quelconque des revendications précédentes, comprenant en outre l'application d'un revêtement non métallique (80) pardessus la carte à circuit imprimé souple (34).

14. Procédé selon l'une quelconque des revendications précédentes, comprenant en outre la fixation de l'élément d'isolation (42) à une plaque frontale (32).

15. Procédé selon la revendication 14, comprenant en outre la fixation de la plaque frontale (32) à un logement (18) d'un système de rasoir de rasage (10).
